# DEMANDE DE BREVET EUROPEEN

(11) **EP 2 955 718 A1**
(43) Date de publication de la demande: **16.12.2015**
(21) Numéro de dépôt: 15171234.6
(22) Date de dépôt: 09.06.2015
(51) Int. Cl.: G11C 13/00, H01L 45/00

(54) **DISPOSITIF DE MEMOIRE VIVE RESISTIVE**

(30) Priorité: 12.06.2014 FR 1455332
(71) Demandeur: COMMISSARIAT A L'ENERGIE ATOMIQUE ET AUX ENERGIES ALTERNATIVES, 75015 Paris (FR); Altis Semiconductor, 75008 Paris (FR)
(72) Inventeur: Dahmani, Faiz, 94210 LA VARENNE SAINT-HILAIRE (FR); Blaise, Philippe, 38000 GRENOBLE (FR); Molas, Gabriel, 38000 GRENOBLE (FR); Vianello, Elisa, 38000 GRENOBLE (FR)
(74) Mandataire: Cabinet Camus Lebkiri

(57) **Abrégé**

Un aspect de l'invention concerne un dispositif de mémoire vive résistive (10) comportant :
- une première électrode (E1) ;
- un électrolyte solide en oxyde métallique (ML) s'étendant sur la première électrode (E1) ;
- une deuxième électrode (E2) apte à fournir des ions mobiles circulant dans l'électrolyte solide en oxyde métallique (ML) vers la première électrode (E1) pour former un filament conducteur entre les première et deuxième électrodes lorsqu'une tension est appliquée entre les première et deuxième électrodes ;
- une couche d'interface (INT1) comprenant un métal de transition des groupes 3, 4, 5 ou 6 du tableau périodique des éléments et un élément chalcogène ;

la couche d'interface (INT1) s'étendant sur l'électrolyte solide en oxyde métallique (ML), la deuxième électrode (E2) s'étendant sur la couche d'interface (INT1).

## Description

### DOMAINE TECHNIQUE DE L'INVENTION

La présente invention concerne le domaine des mémoires réinscriptibles non volatiles, et plus spécifiquement celui des mémoires vives résistives. Une mémoire vive résistive comprend des première et seconde électrodes séparées par une couche en matériau électriquement isolant, et passe d'un état isolant à un état conducteur par formation d'un filament conducteur entre les première et seconde électrodes.

### ARRIERE-PLAN TECHNOLOGIQUE DE L'INVENTION

Les mémoires vives à résistance variable (appelées mémoires RRAM pour « Resistive Random Access Memories » en anglais) sont aujourd'hui le sujet d'une grande attention, en raison notamment de leur faible consommation électrique et leur vitesse de fonctionnement élevée.

Une cellule mémoire de type résistive présente au moins deux états : un état fortement résistif « HRS » (« High Résistance State »), appelé également état « OFF », et un état faiblement résistif « LRS » (« Low Résistance State ») ou état « ON ». Elle peut donc être utilisée pour stocker une information binaire.

On peut distinguer trois types de mémoires résistives : les mémoires à base de mécanisme thermochimique, les mémoires à base de changement de valence, et les mémoires à base de métallisation électrochimique.

Le domaine de la présente invention concerne plus particulièrement cette dernière catégorie basée sur des matériaux à conduction ionique (mémoires CBRAM ou « Conductive Bridging RAM »). Le fonctionnement réside dans la formation et la rupture réversibles d'un filament conducteur dans un électrolyte solide, par dissolution d'une électrode soluble. Ces mémoires sont prometteuses de par leur faibles tensions de programmation (de l'ordre du Volt), leur temps de programmation court (<1 µs), leur faible consommation et leur faible coût d'intégration. De plus, ces mémoires peuvent être intégrées dans les niveaux de métallisation de la logique d'un circuit (« above IC »), ce qui permet d'augmenter la densité d'intégration du circuit. Du point de vue de l'architecture, elles requièrent seulement un dispositif de sélection, un transistor ou une diode par exemple.

Le fonctionnement des mémoires CBRAM est basé sur la formation, au sein d'un électrolyte solide, d'un ou plusieurs filaments métalliques (appelés également « dendrites ») entre deux électrodes, lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament métallique, de manière à supprimer ou à réduire considérablement la conduction électrique due à la présence du filament.

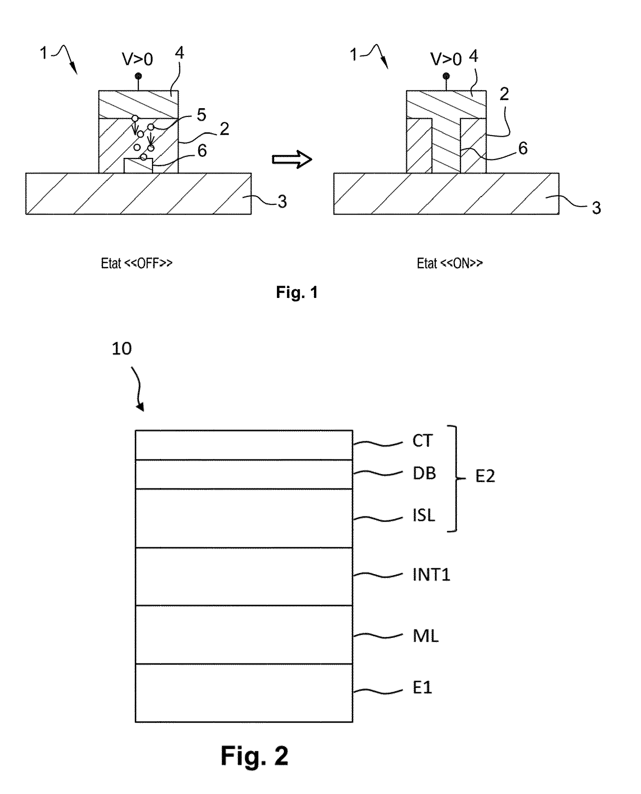

La figure 1 illustre schématiquement le passage d'un état « OFF » à un état « ON » pour un dispositif mémoire 1 de type CBRAM.

Ce dispositif 1 est formé par un empilement de type Métal/Conducteur ionique/Métal. Il comporte un électrolyte solide 2, par exemple à base de chalcogénure dopé (ex. GeS) ou d'oxyde (ex. Al₂O₃). L'électrolyte 2 est disposé entre une électrode inférieure 3, par exemple en Pt, formant une cathode inerte, et une électrode supérieure 4 comportant une portion de métal ionisable, par exemple du cuivre, et formant une anode. Une portion de métal ionisable est une portion de métal pouvant former des ions métalliques (ici des ions Cu²⁺), lorsqu'elle est soumise à un potentiel électrique approprié. Le dispositif 1 représenté sur la figure 1 forme typiquement un point mémoire, c'est-à-dire une cellule mémoire unitaire, d'une mémoire comportant une multitude de ces dispositifs mémoires.

Comme indiqué précédemment, l'état mémoire d'un dispositif mémoire CBRAM résulte de la différence de résistivité électrique entre deux états : « ON » et « OFF ».

A l'état « OFF », les ions métalliques (ici les ions Cu²⁺ pour une électrode soluble comprenant du Cu) issus de la portion de métal ionisable sont dispersés dans tout l'électrolyte solide 2. Ainsi, aucun contact électrique n'est établi entre la cathode 3 et l'anode 4, c'est-à-dire entre l'électrode supérieure et l'électrode inférieure. L'électrolyte solide comporte une zone électriquement isolante de grande résistivité entre l'anode et la cathode.

Lorsqu'un potentiel V positif est appliqué sur l'électrode soluble supérieure 4 (l'anode), une réaction d'oxydo-réduction a lieu à cette électrode, créant des ions mobiles 5. Dans le cas d'une électrode 4 de cuivre, la réaction suivante a lieu :

Cu → Cu²⁺ + 2e⁻.

Les ions 5 se déplacent alors dans l'électrolyte 2 sous l'effet du champ électrique appliqué aux électrodes. La vitesse de déplacement dépend de la mobilité de l'ion dans l'électrolyte en question, ce qui guide le choix du couple électrode soluble/électrolyte (exemples : Ag/GeS ; Cu/Al₂O₃...). Les vitesses de déplacement des ions sont de l'ordre du nm/ns.

Arrivés à l'électrode inerte 3 (la cathode), les ions 5 sont réduits de par la présence d'électrons fournis par l'électrode 3, entraînant la croissance d'un filament métallique 6 selon la réaction suivante :

Cu²⁺ + 2 e⁻ → Cu

Le filament 6 croît préférentiellement dans la direction de l'électrode soluble 4.

La mémoire 1 passe alors dans l'état « ON » lorsque le filament 6 permet le contact entre les électrodes 3 et 4, rendant l'empilement conducteur. Cette phase est appelé « SET » de la mémoire.

Pour passer à l'état « OFF » (phase de « RESET » de la mémoire), une tension V négative est appliquée sur l'électrode supérieure 4, entrainant la dissolution du filament conducteur. Pour justifier cette dissolution, des mécanismes thermiques (échauffement) et d'oxydoréduction sont généralement invoqués.

Souvent, l'électrolyte 2 contient dans l'état « OFF » un filament résiduel 6 en contact avec la cathode 3. Celui-ci provient de la phase de SET précédente et n'a pas été dissous complétement lors du RESET de la mémoire. Le filament est dit résiduel lorsqu'il n'établit pas une conduction électrique suffisante entre les électrodes pour obtenir l'état « ON ».

Une voie de développement pour les mémoires CBRAM concerne la rétention de l'information, c'est-à-dire la rétention de l'état « OFF » et de l'état « ON ». On cherche à améliorer la stabilité des états isolant et conducteur, notamment pour des températures de fonctionnement élevées. De nombreuses études portent sur ces mémoires CBRAM pour améliorer leurs performances électriques. Une des difficultés des mémoires CBRAM concerne en effet la difficulté de former le filament dans l'électrolyte.

### RESUME DE L'INVENTION

Un objectif de l'invention est ainsi de proposer une cellule mémoire CBRAM à base d'oxyde métallique présentant une rétention de l'information améliorée. Un autre objectif de l'invention est de proposer une cellule mémoire CBRAM à base d'oxyde métallique présentant des performances électriques améliorées.

Un aspect de l'invention concerne ainsi un dispositif de mémoire vive résistive comportant :
- une première électrode, dite « électrode inerte » ;
- un électrolyte solide en oxyde métallique s'étendant au moins partiellement sur la première électrode ;
- une deuxième électrode, dite « électrode soluble », les première et deuxième électrodes étant respectivement agencées de part et d'autre dudit électrolyte solide en oxyde métallique, la deuxième électrode étant apte à fournir des ions mobiles circulant dans l'électrolyte solide en oxyde métallique vers la première électrode pour former un filament conducteur entre les première et deuxième électrodes lorsqu'une tension est appliquée entre les première et deuxième électrodes ;
ledit dispositif comportant une couche d'interface comprenant :
- un métal de transition des groupes 3, 4, 5 ou 6 du tableau périodique des éléments ;
- un élément chalcogène ;
la couche d'interface s'étendant au moins partiellement sur l'électrolyte solide en oxyde métallique, la deuxième électrode s'étendant au moins partiellement sur la couche d'interface.

On entend par «élément chalcogène» un élément du groupe 16 du tableau périodique des éléments. Ladite couche d'interface permet avantageusement de contribuer à la création d'une pluralité de lacunes d'oxygène à l'interface avec l'électrolyte solide en oxyde métallique. Cette pluralité de lacunes d'oxygène permet de faciliter le déplacement des ions mobiles, et donc la formation du filament conducteur. On contribue ainsi à diminuer la tension de forming, c'est-à-dire la tension à appliquer entre l'électrode soluble et l'électrode inerte pour permettre la formation du filament conducteur lors de l'étape de forming. La couche d'interface permet également avantageusement de contribuer à l'amélioration de la rétention de l'information, c'est-à-dire à l'augmentation de la persistance du filament conducteur au sein de l'électrolyte solide à base d'oxyde métallique, lorsqu'aucune tension n'est appliquée. Ladite couche d'interface est en effet apte à se comporter comme une barrière pour les ions mobiles formant le filament conducteur, évitant ainsi toute dissolution dudit filament.

Outre les caractéristiques qui viennent d'être évoquées dans le paragraphe précédent, le dispositif de mémoire vive résistive selon un aspect de l'invention peut présenter une ou plusieurs caractéristiques complémentaires parmi les suivantes, considérées individuellement ou selon toutes les combinaisons techniquement possibles :
- Le métal de transition des groupes 3, 4, 5 ou 6 du tableau périodique des éléments est avantageusement du titane Ti. En effet l'oxyde de titane (III, IV) a une enthalpie de formation très élevée permettant ainsi au titane de prendre plus facilement de l'oxygène à l'électrolyte solide en oxyde métallique, c'est-à-dire à la couche mémoire, et de générer ainsi des lacunes d'oxygène dans l'électrolyte solide en oxyde métallique.
- Alternativement, ledit métal de transition est de l'hafnium Hf, du zirconium Zr, du scandium Sc, du vanadium V, du chrome Cr, de l'yttrium Y, du niobium Nb ou du tantale Ta.
- L'élément chalcogène est avantageusement du tellure Te. En effet, Le tellure Te présente une mobilité et une aptitude à ségréguer qui contribuent à favoriser une séparation de phases au sein de la couche d'interface.
- Alternativement, l'élément chalcogène est du soufre S ou du sélénium Se.
- La deuxième électrode comporte avantageusement :
   ∘ une première couche, dite « couche de source d'ions », réalisée à partir d'un élément conducteur soluble et s'étendant au moins partiellement sur la couche d'interface ;
   ∘ une deuxième couche, dite « barrière de diffusion », réalisée à partir d'un matériau conducteur et s'étendant au moins partiellement sur la couche de source d'ions ;
   ∘ une troisième couche, dite « couche de contact électrique », réalisée à partir d'un matériau conducteur et s'étendant au moins partiellement sur la barrière de diffusion ;
   la barrière de diffusion étant apte à limiter au moins partiellement la diffusion du matériau conducteur de la couche de contact électrique vers la couche de sources d'ions sur une gamme de température donnée.

Dans la présente description, on entend par « élément conducteur soluble » ou « matériau conducteur soluble » un élément ou un matériau apte à participer à la formation d'un filament conducteur au sein de l'électrolyte solide en oxyde métallique, c'est-à-dire un élément ou un matériau conducteur apte à libérer des ions mobiles pour la formation dudit filament conducteur au sein de l'électrolyte solide en oxyde métallique. La barrière de diffusion de la deuxième électrode contribue avantageusement à contrôler efficacement la concentration du métal de transition des groupes 3, 4, 5 ou 6 du tableau périodique au sein de la couche d'interface. La barrière de diffusion est préférentiellement réalisée en nitrure de titane TiN, en nitrure de tantale TaN, en ruthénium Ru ou en nitrure de ruthénium RuN.
- La couche d'interface comporte avantageusement un élément conducteur soluble. L'élément conducteur soluble est préférentiellement du cuivre Cu ou du zinc Zn ou de l'argent Ag, ou tout alliage binaire ou tertiaire de cuivre Cu et/ou de zinc Zn et/ou d'argent Ag. Dans ce dernier cas, l'élément conducteur soluble peut notamment être du nitrure de cuivre Cu₃N ou du nitrure de zinc Zn₃N₂ ou du nitrure d'argent Ag₃N.
- Dans le cas où le dispositif de mémoire vive résistive selon un aspect de l'invention comprend une couche de source d'ions et une couche d'interface comportant un élément conducteur soluble, ladite couche d'interface et la couche de source d'ions comportent avantageusement le même élément conducteur soluble.
- Alternativement, dans le cas où le dispositif de mémoire vive résistive selon un aspect de l'invention comprend une couche de source d'ions et une couche d'interface comportant un élément conducteur soluble, l'élément conducteur soluble de la couche de source d'ions pourra être distinct de l'élément conducteur soluble de la couche d'interface.

Un autre aspect de l'invention concerne un premier procédé de fabrication d'un dispositif de mémoire vive résistive selon un aspect de l'invention, comportant les étapes suivantes :
a) formation de la première électrode ;
b) formation, sur la première électrode, de l'électrolyte solide en oxyde métallique ;
c) formation, sur l'électrolyte solide en oxyde métallique, de la couche d'interface ;
d) formation, sur la couche d'interface, de la deuxième électrode.

Outre les étapes citées dans le paragraphe précédent, le procédé de fabrication d'un dispositif de mémoire vive résistive selon le premier mode de réalisation de l'invention peut avantageusement présenter une ou plusieurs étapes complémentaires parmi les suivantes, considérées individuellement ou selon toutes les combinaisons techniquement possibles :
- Selon une première alternative, l'étape c) comporte les sous-étapes suivantes :
   ∘ dépôt, sur l'électrolyte solide en oxyde métallique, d'une couche comportant l'élément chalcogène ;
   ∘ dépôt, sur la couche comportant ledit élément chalcogène, d'une couche comportant le métal de transition des groupes 3, 4, 5 ou 6 du tableau périodique des éléments ;
   ∘ recuit thermique pour la diffusion au moins partielle dudit métal de transition dans la couche comportant ledit élément chalcogène, et l'obtention de la couche d'interface ;
   et l'étape d) comporte la sous-étape suivante :
   ∘ dépôt, sur la couche d'interface, d'une couche de source d'ions comportant un élément conducteur soluble.
- Selon une deuxième alternative, l'étape c) comporte les sous-étapes suivantes :
   ∘ dépôt, sur l'électrolyte solide en oxyde métallique, d'une couche comportant le métal de transition des groupes 3, 4, 5 ou 6 du tableau périodique élément, l'élément chalcogène et un élément conducteur soluble ;
   ∘ recuit thermique pour la séparation de la couche comportant ledit métal de transition, ledit élément chalcogène et ledit élément conducteur soluble en :
      - la couche d'interface de formule PₓN_{y}T_{1-(x+y)}, P étant l'élément conducteur soluble, N l'élément chalcogène et T le métal de transition, avec x ≤ 10% et y ≤ 55%, la couche d'interface s'étendant au contact de l'électrolyte solide en oxyde métallique ;
      - une couche de source d'ions, s'étendant au contact de la couche d'interface et comportant ledit élément conducteur soluble.
- Selon une troisième alternative, l'étape c) comporte les sous-étapes suivantes :
   ∘ dépôt, sur l'électrolyte solide en oxyde métallique, d'une couche comportant l'élément chalcogène et l'élément conducteur soluble ;
   ∘ dépôt, sur la couche comportant ledit élément chalcogène et ledit élément conducteur soluble, d'une couche comportant le métal de transition des groupes 3, 4, 5 ou 6 du tableau périodique des éléments ;
   ∘ recuit thermique pour la diffusion au moins partielle dudit métal de transition dans la couche comportant ledit élément chalcogène et ledit élément conducteur soluble, et l'obtention de la couche d'interface ;
   et l'étape d) comporte la sous-étape suivante :
   ∘ dépôt, sur la couche d'interface, d'une couche de source d'ions comportant ledit élément conducteur soluble.
- Selon une quatrième alternative, l'étape c) comporte les sous-étapes suivantes :
   ∘ dépôt, sur l'électrolyte solide en oxyde métallique, d'une couche comportant le métal de transition des groupes 3, 4, 5 ou 6 du tableau périodique des éléments et l'élément chalcogène ;
   ∘ dépôt, sur la couche comportant ledit métal de transition et ledit élément chalcogène, d'une couche comportant l'élément conducteur soluble ;
   ∘ recuit thermique pour la diffusion au moins partielle de l'élément conducteur soluble dans la couche comportant ledit métal de transition et ledit élément chalcogène, et l'obtention de la couche d'interface ;
   et l'étape d) comporte la sous-étape suivante :
   ∘ dépôt, sur la couche d'interface, d'une couche de source d'ions comportant l'élément conducteur soluble.
- Selon l'une quelconque des première, deuxième, troisième ou quatrième alternatives, l'étape d) comporte les sous-étapes suivantes :
   ∘ dépôt, sur la couche de source d'ions comportant l'élément conducteur soluble, d'une barrière de diffusion réalisée à partir d'un matériau conducteur ;
   ∘ dépôt, sur la barrière de diffusion, d'une couche de contact électrique réalisée à partir d'un matériau conducteur ;
   ∘ la couche de source d'ions, la barrière de diffusion et la couche de contact électrique formant la deuxième électrode, la barrière de diffusion étant apte à limiter au moins partiellement la diffusion du matériau conducteur de la couche de contact électrique vers la couche de sources d'ions sur une gamme de température donnée.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique du passage d'un état « OFF » à un état « ON » pour un dispositif mémoire de type CBRAM.
- La figure 2 illustre schématiquement une cellule mémoire CBRAM à base d'oxyde métallique selon un aspect de l'invention.
- Les figures 3a, 3b, 3c et 3d montrent des étapes d'un premier procédé de fabrication d'une cellule mémoire CBRAM à base d'oxyde métallique selon un premier mode de réalisation de l'invention.
- Les figures 4a, 4b, 4c et 4d montrent des étapes d'un deuxième procédé de fabrication d'une cellule mémoire CBRAM à base d'oxyde métallique selon le premier mode de réalisation de l'invention.
- Les figures 5a, 5b, 5c et 5d montrent des étapes d'un premier procédé de fabrication d'une cellule mémoire CBRAM à base d'oxyde métallique selon un deuxième mode de réalisation de l'invention.
- Les figures 6a, 6b, 6c et 6d montrent des étapes d'un deuxième procédé de fabrication d'une cellule mémoire CBRAM à base d'oxyde métallique selon le deuxième mode de réalisation de l'invention.

### DESCRIPTION DETAILLEE D'AU MOINS UN MODE DE REALISATION DE L'INVENTION

Sauf précision contraire, un même élément apparaissant sur des figures différentes présente une référence unique.

Dans la présente description, on emploiera indifféremment les expressions « cellule mémoire CBRAM », « dispositif mémoire de type CBRAM » et « dispositif de mémoire vive résistive ».

La figure 1, qui montre une représentation schématique du passage d'un état « OFF » à un état « ON » pour un dispositif mémoire de type CBRAM, a été précédemment décrite.

La figure 2 illustre schématiquement une cellule mémoire CBRAM 10 à base d'oxyde métallique selon un premier mode de réalisation de l'invention. La cellule mémoire CBRAM 10 selon le premier mode de réalisation de l'invention comporte :
- une première électrode E1, également appelée « électrode inerte» ou « cathode », s'étendant suivant un plan de référence ;
- un électrolyte solide ML en oxyde métallique, s'étendant sur la première électrode E1, parallèlement au plan de référence ;
- une couche d'interface INT1 d'un premier type s'étendant sur l'électrolyte solide ML en oxyde métallique, parallèlement au plan de référence ;
- une deuxième électrode E2, également appelée « électrode soluble » ou « anode », s'étendant sur la couche d'interface INT, parallèlement au plan de référence.

La deuxième électrode E2 comprend préférentiellement :
- une première couche ISL, dite « couche de source d'ions » réalisée à partir d'un élément conducteur soluble et s'étendant sur la couche d'interface INT1 du premier type ;
- une deuxième couche DB, dite « barrière de diffusion », réalisée à partir d'un matériau conducteur et s'étendant sur la couche de source d'ions ISL ;
- une troisième couche CT, dite « couche de contact électrique », réalisée à partir d'un matériau conducteur et s'étendant au moins partiellement sur la barrière de diffusion DB.

La première électrode E1 est réalisée en un matériau conducteur inerte, c'est-à-dire ne participant pas à la formation d'un filament conducteur au sein de l'électrolyte solide ML en oxyde métallique. Ce matériau conducteur inerte peut typiquement être :
- du ruthénium Ru,
- du dioxyde de ruthénium RuO₂,
- du tungstène W,
- du nitrure de tungstène WNₓ,
- du nitrure de tantale TaN,
- du nitrure de titane TiN, ou tout alliage ou combinaison des éléments qui viennent d'être cités.

Dans l'exemple particulier représenté à la figure 2, l'électrolyte solide ML en oxyde métallique est réalisé en oxyde de gadolinium Gd₂O₃. En particulier, l'électrolyte solide ML en oxyde métallique peut être réalisé en oxyde de gadolinium Gd₂O₃ hybride, c'est-à-dire comportant au moins une première sous-couche en oxyde de gadolinium Gd₂O₃ et une deuxième sous-couche en oxyde de gadolinium Gd₂O₃. La première sous-couche est une sous-couche standard formée par pulvérisation RF utilisant un gaz d'argon Ar, de xénon Xe ou de krypton Kr. La deuxième sous-couche est formée par pulvérisation RF utilisant, en plus d'un gaz principal d'argon Ar, de xénon Xe ou de krypton Kr, de l'oxygène comme deuxième gaz de telle sorte que le ratio oxygène/gaz principal soit inférieur ou égal à 1/16. Lesdites première et deuxième sous-couches sont, au moins partiellement, directement en contact l'une avec l'autre, et lesdites première et deuxième sous-couches sont typiquement sensiblement de même épaisseur.

Alternativement, les configurations suivantes, considérées individuellement ou selon toutes les combinaisons techniquement possibles, pourront être adoptées :
- l'électrolyte solide ML en oxyde métallique est réalisé en oxyde d'aluminium Al₂O₃, du dioxyde de zirconium ZrO₂, du dioxyde de titane TiO₂ ou de l'oxyde de tantale Ta₂O₅ ;
- l'électrolyte solide ML en oxyde métallique comporte au moins une bicouche de type Gd₂O₃/Al₂O₃, Gd₂O₃/GeO, Gd₂O₃/La₂O₃, Gd₂O₃/Li₂O, Gd₂O₃/B₂O₃, Gd₂O₃/WO₂, Gd₂O₃/VO₂, Gd₂O₃/V₂O₅, Gd₂O₃/MgO ou Gd₂O₃/MgAl₂O₄ ;
- l'électrolyte solide ML en oxyde métallique comporte au moins une tricouche de type Gd₂O₃/Al₂O₃/Gd₂O₃, Gd₂O₃/GeO/Gd₂O₃, Gd₂O₃/La₂O₃/Gd₂O₃, Gd₂O₃/Li₂O/Gd₂O₃, Gd₂O₃/B₂O₃/Gd₂O₃, Gd₂O₃/WO₂/Gd₂O₃, Gd₂O₃/VO₂/Gd₂O₃, Gd₂O₃/V₂O₅/Gd₂O₃, Gd₂O₃/MgO/Gd₂O₃, Gd₂O₃/MgAl₂O₄/Gd₂O₃.

La couche de source d'ions ISL de la deuxième électrode E2 est réalisée en un matériau conducteur soluble, c'est-à-dire participant à la formation d'un filament conducteur au sein de l'électrolyte solide ML en oxyde métallique. Ce matériau conducteur soluble peut être par exemple :
- du cuivre Cu ;
- du zinc Zn ;
- de l'argent Ag ;
- du nitrure de cuivre Cu₃N ;
- du nitrure de zinc Zn₃N₂ ;
- du nitrure d'argent Ag₃N.

La barrière de diffusion DB de la deuxième électrode E2 est réalisée en un matériau conducteur, tel que par exemple :
- du nitrure de titane TiN ;
- du nitrure de tantale TaN ;
- du ruthénium Ru ou du nitrure de ruthénium RuN.

La barrière de diffusion DB est typiquement une couche mince, d'épaisseur inférieure ou égale à 5 nm. L'épaisseur de la barrière de diffusion DB est mesurée selon une direction sensiblement perpendiculaire au plan de référence.

La barrière de diffusion DB permet avantageusement de contribuer à un contrôle efficace de la concentration du métal de transition dans la couche d'interface INT.

La couche de contact électrique CT de la deuxième électrode E2 est réalisée à partir d'un matériau conducteur, tel que par exemple du Ti-TiN, c'est-à-dire une couche de Ti et une couche de TiN, ou du Ta-TaN, c'est-à-dire une couche de Ta et une couche de TaN.

Selon le premier mode de réalisation de l'invention, la couche d'interface INT1 du premier type comporte :
- un métal de transition des groupes 3, 4, 5 ou 6 du tableau périodique des éléments, dit par la suite « métal de transition », et
- un élément chalcogène.

Ledit métal de transition est préférentiellement du titane Ti, ou alternativement de l'hafnium Hf ou du zirconium Zr. Ledit élément chalcogène est préférentiellement du tellure Te, ou alternativement du soufre S ou du sélénium Se.

La couche d'interface INT1 du premier type selon le premier mode de réalisation de l'invention est également désignée par l'acronyme ICL (de l'anglais « Ion Crossing Layer »).

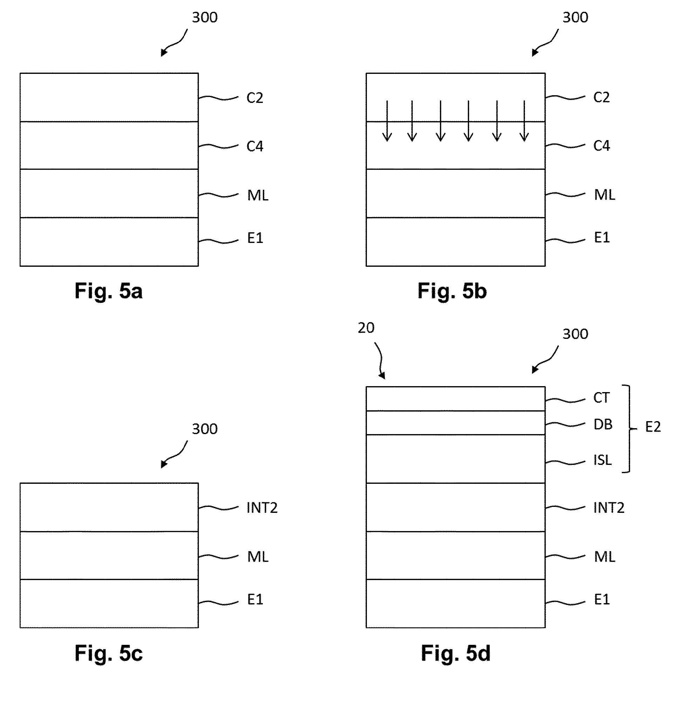

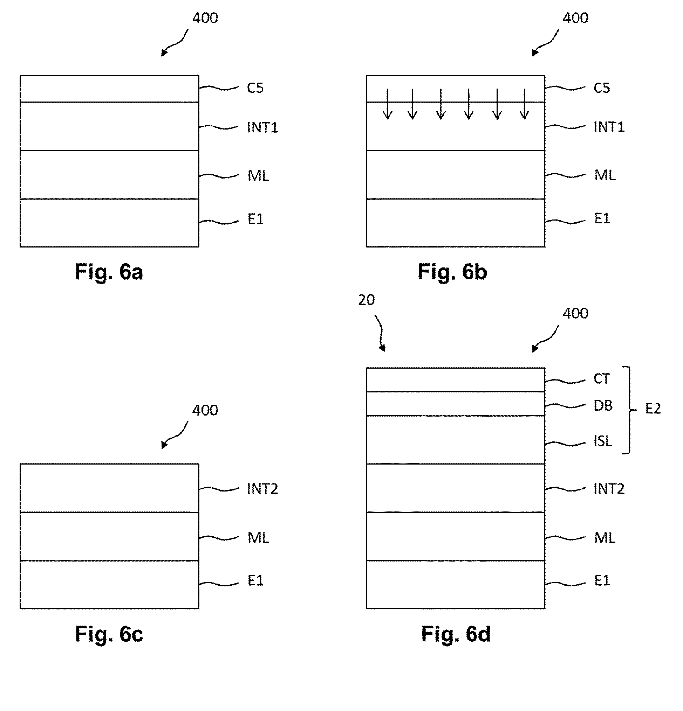

Selon un deuxième mode de réalisation de l'invention, la cellule mémoire CBRAM (référence 20 des figures 5d et 6d) comprend une couche d'interface INT2 d'un deuxième type, comportant :
- un métal de transition tel que précédemment défini,
- un élément chalcogène, et
- un élément conducteur soluble.

Ladite couche d'interface INT2 du deuxième type est notamment représentée aux figures 5d et 6d, qui sont décrites par la suite.

De même que précédemment :
- le métal de transition de la couche d'interface INT2 du deuxième type est préférentiellement du titane Ti, ou alternativement de l'hafnium Hf ou du zirconium Zr, et
- l'élément chalcogène de la couche d'interface INT2 du deuxième type est préférentiellement du tellure Te, ou alternativement du soufre S ou du sélénium Se.

L'élément conducteur soluble de la couche d'interface INT2 du deuxième type est avantageusement le même que l'élément conducteur soluble de la couche de source d'ions ISL. Ainsi, par exemple, lorsque la couche de source d'ions ISL est réalisée à partir de cuivre Cu, l'élément conducteur soluble de la couche d'interface INT2 du deuxième type est avantageusement du cuivre Cu. La couche d'interface INT2 du deuxième type est également désignée par l'acronyme IBL (de l'anglais « Ion Buffer Layer »). Le choix du matériau conducteur soluble de la couche de source d'ions ISL détermine donc avantageusement l'élément conducteur soluble présent dans ladite couche d'interface INT2 du deuxième type.

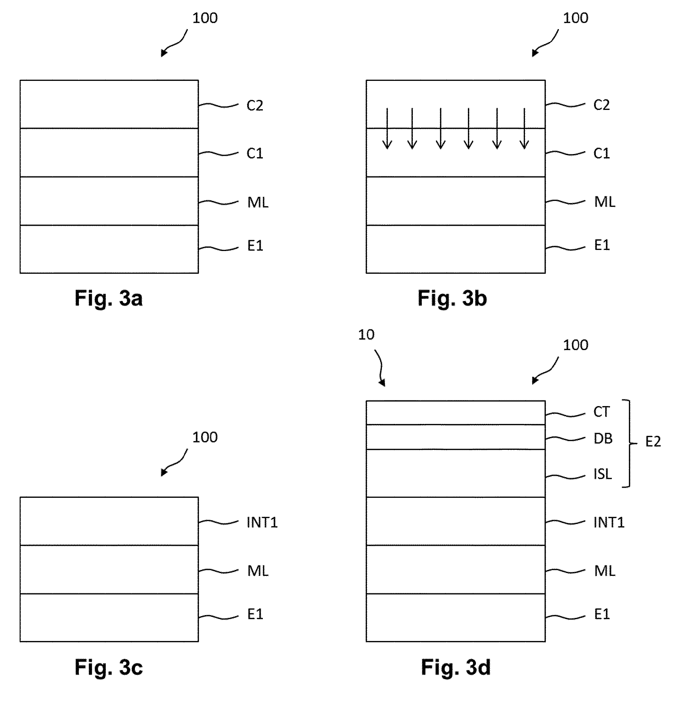

Les figures 3a à 3d illustrent schématiquement les étapes d'un premier procédé 100 de fabrication d'une cellule mémoire CBRAM 10 à base d'oxyde métallique selon le premier mode de réalisation de l'invention, dans lequel la cellule mémoire CBRAM 10 comporte la couche d'interface du premier type INT1.

Le procédé 100 de fabrication d'une cellule mémoire CBRAM 10 à base d'oxyde métallique selon le premier mode de réalisation comporte tout d'abord les étapes suivantes :
- formation de la première électrode E1 ;
- formation, sur la première électrode E1, de l'électrolyte solide en oxyde métallique ML ;
- dépôt, sur l'électrolyte solide en oxyde métallique ML, d'une couche C1 comportant l'élément chalcogène ;
- dépôt, sur la couche C1 comportant l'élément chalcogène, d'une couche C2 comportant le métal de transition.

La figure 3a montre schématiquement le résultat obtenu à l'issue des étapes qui viennent d'être citées. Dans l'exemple particulier de la figure 3a, le métal de transition de la couche C2 est du titane Ti, l'électrolyte solide en oxyde métallique ML est réalisé en oxyde de gadolinium et l'élément chalcogène de la couche C1 est du tellure Te.

Le premier procédé 100 de fabrication d'une cellule mémoire CBRAM 10 à base d'oxyde métallique selon le premier mode de réalisation comporte ensuite une étape de recuit thermique, illustrée à la figure 3b. Cette étape de recuit thermique s'effectue typiquement à une température comprise entre 100°C et 450°C, et pendant une durée comprise entre 1 minute et 20 minutes.

L'étape de recuit thermique permet la diffusion au moins partielle du métal de transition de la couche C2, précédemment déposée, dans la couche C1 comportant l'élément chalcogène. A l'issue de l'étape de recuit thermique, la diffusion du métal de transition dans la couche C1 permet l'obtention de la couche d'interface du premier type INT1, comportant le métal de transition et l'élément chalcogène. La figure 3c illustre schématiquement l'empilement ainsi obtenu à l'issue de l'étape de recuit thermique.

Selon une première alternative, le premier procédé 100 de fabrication d'une cellule mémoire CBRAM 10 à base d'oxyde métallique selon le premier mode de réalisation peut comporter, en plus de l'étape de recuit thermique qui vient d'être décrite, une étape d'irradiation UV. Cette étape d'irradiation UV s'effectue alors typiquement avec une puissance moyenne comprise entre 20 mW/cm² et 150 mW/cm², pendant une durée comprise entre 1 minute et 20 minutes, et pour des longueurs d'ondes comprises entre 100 nm et 400 nm.

L'étape d'irradiation UV permet avantageusement de casser des liaisons dans l'électrolyte solide en oxyde métallique, et donc de générer des défauts susceptibles de promouvoir des lacunes d'oxygène dans l'électrolyte solide en oxyde métallique.

Selon cette première alternative, les étapes de recuit thermique et d'irradiation UV peuvent alors avoir lieu simultanément ou non. Ainsi, d'une manière générale :
- l'étape de recuit thermique pourra indifféremment débuter avant, en même temps ou après le début de l'étape d'irradiation UV, et
- l'étape de recuit thermique pourra indifféremment se terminer avant, en même temps ou après la fin de l'étape d'irradiation UV.

Le premier procédé 100 de fabrication d'une cellule mémoire CBRAM 10 à base d'oxyde métallique selon le premier mode de réalisation comporte finalement les étapes suivantes :
- dépôt, sur la couche d'interface du premier type INT1, de la couche de source d'ions ISL comportant l'élément conducteur soluble ;
- dépôt, sur la couche de source d'ions ISL, de la barrière de diffusion DB ;
- dépôt, sur la barrière de diffusion DB, de la couche de contact électrique CT.

La couche de source d'ions ISL, la barrière de diffusion DB et la couche de contact électrique CT forment la deuxième électrode E2.

La figure 3d illustre schématiquement la cellule mémoire CBRAM 10 à base d'oxyde métallique selon le premier mode de réalisation de l'invention, obtenue par le procédé 100 de fabrication ; cette cellule 10 est identique à celle illustrée en figure 2.

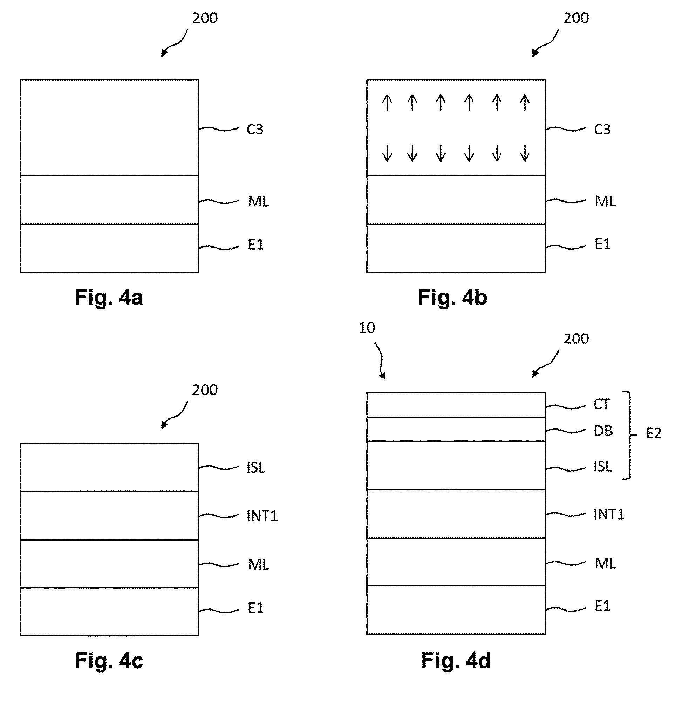

Les figures 4a à 4d illustrent schématiquement les étapes d'un deuxième procédé 200 de fabrication d'une cellule mémoire CBRAM 10 à base d'oxyde métallique selon le premier mode de réalisation de l'invention, dans lequel la cellule mémoire CBRAM 10 comporte la couche d'interface du premier type INT1.

Le deuxième procédé 200 de fabrication d'une cellule mémoire CBRAM 10 à base d'oxyde métallique selon le premier mode de réalisation comporte tout d'abord, de même que le premier procédé 100, les étapes suivantes :
- formation de la première électrode E1 ;
- formation, sur la première électrode E1, de l'électrolyte solide en oxyde métallique ML.

Le deuxième procédé 200 comporte ensuite une étape de dépôt, sur l'électrolyte solide en oxyde métallique ML, d'une couche C3 comportant le métal de transition, l'élément chalcogène et un élément conducteur soluble. L'élément conducteur soluble de la couche C3 est apte à participer à la formation d'un filament conducteur au sein de l'électrolyte solide en oxyde métallique ML et peut donc par exemple être :
- du cuivre Cu ;
- du zinc Zn ;
- de l'argent Ag ;
- du nitrure de cuivre Cu₃N ;
- du nitrure de zinc Zn₃N₂ ;
- du nitrure d'argent Ag₃N.

La figure 4a montre schématiquement le résultat obtenu à l'issue des étapes qui viennent d'être citées. Dans l'exemple particulier de la figure 4a, la couche C3 comporte du titane Ti, du tellure Te et du cuivre Cu.

Le deuxième procédé 200 de fabrication d'une cellule mémoire CBRAM 10 à base d'oxyde métallique selon le premier mode de réalisation comporte ensuite, de même que le premier procédé 100, une étape de recuit thermique, illustrée à la figure 4b. Cette étape de recuit thermique s'effectue typiquement à une température comprise entre 100°C et 450°C, et pendant une durée comprise entre 1 minute et 20 minutes.

L'étape de recuit thermique permet la séparation au moins partielle des espèces de la couche C3 et l'obtention :
- de la couche d'interface du premier type INT1, s'étendant au contact de l'électrolyte solide en oxyde métallique ML et comportant le métal de transition et l'élément chalcogène, et
- de la couche de source d'ions ISL, s'étendant au contact de la couche d'interface du premier type INT1 et comportant l'élément conducteur soluble.

La figure 4c illustre schématiquement l'empilement ainsi obtenu à l'issue de l'étape de recuit thermique.

Selon une première alternative, le deuxième procédé 200 de fabrication d'une cellule mémoire CBRAM 10 à base d'oxyde métallique selon le premier mode de réalisation peut comporter, en plus de l'étape de recuit thermique qui vient d'être décrite, une étape d'irradiation UV. Cette première alternative a été précédemment décrite dans le cas du premier procédé 100. L'étape d'irradiation UV permet avantageusement de casser des liaisons dans l'électrolyte solide en d'oxyde métallique, et donc de générer des défauts susceptibles de promouvoir des lacunes d'oxygène dans l'électrolyte solide en oxyde métallique.

Le deuxième procédé 200 de fabrication d'une cellule mémoire CBRAM 10 à base d'oxyde métallique selon le premier mode de réalisation comporte finalement les étapes suivantes :
- dépôt, sur la couche de source d'ions ISL, de la barrière de diffusion DB ;
- dépôt, sur la barrière de diffusion DB, de la couche de contact électrique CT.

La couche de source d'ions ISL, la barrière de diffusion DB et la couche de contact électrique CT forment la deuxième électrode E2.

La figure 4d illustre schématiquement la cellule mémoire CBRAM 10 à base d'oxyde métallique selon le premier mode de réalisation de l'invention, obtenue par le procédé 200 de fabrication. Cette cellule 10 est identique à celle illustrée en figure 2.

Les figures 5a à 5d montrent schématiquement les étapes d'un premier procédé 300 de fabrication d'une cellule mémoire CBRAM à base d'oxyde métallique selon le deuxième mode de réalisation de l'invention, dans lequel la cellule mémoire CBRAM 20 comporte la couche d'interface du deuxième type INT2.

Le premier procédé 300 de fabrication de la cellule mémoire CBRAM 20 à base d'oxyde métallique selon le deuxième mode de réalisation comporte tout d'abord les étapes suivantes :
- formation de la première électrode E1 ;
- formation, sur la première électrode E1, de l'électrolyte solide en oxyde métallique ML ;
- dépôt, sur l'électrolyte solide en oxyde métallique ML, d'une couche C4 comportant l'élément chalcogène et un élément conducteur soluble ;
- dépôt, sur la couche C4 comportant l'élément chalcogène et l'élément conducteur soluble, d'une couche C2 comportant le métal de transition.

Le choix de l'élément conducteur soluble de la couche C4 est déterminé par le type de matériau conducteur soluble que l'on souhaite utiliser par la suite pour réaliser la couche de source d'ions ISL. Par exemple, dans le cas où l'on souhaite réaliser ultérieurement une couche de source d'ions ISL en cuivre Cu, l'élément conducteur soluble de la couche C4 est préférentiellement du cuivre Cu.

La figure 5a montre schématiquement le résultat obtenu à l'issue des étapes qui viennent d'être citées. Dans l'exemple particulier de la figure 5a, l'électrolyte solide en oxyde métallique ML est réalisé en oxyde de gadolinium et la couche C4 comporte du tellure Te et du cuivre Cu.

Le premier procédé 300 de fabrication de la cellule mémoire CBRAM 20 à base d'oxyde métallique selon le deuxième mode de réalisation comporte ensuite une étape de recuit thermique, illustrée à la figure 5b. Cette étape de recuit thermique s'effectue typiquement à une température comprise entre 100°C et 450°C, et pendant une durée comprise entre 1 minute et 20 minutes.

L'étape de recuit thermique permet la diffusion au moins partielle du métal de transition de la couche C2, précédemment déposée, dans la couche C4 comportant l'élément chalcogène et l'élément conducteur soluble. A l'issue de l'étape de recuit thermique, la diffusion du métal de transition dans la couche C4 permet l'obtention de la couche d'interface du deuxième type INT2, comportant le métal de transition, l'élément chalcogène et l'élément conducteur soluble. La figure 5c illustre schématiquement l'empilement ainsi obtenu à l'issue de l'étape de recuit thermique.

Selon une première alternative, le premier procédé 300 de fabrication de la cellule mémoire CBRAM 20 à base d'oxyde métallique selon le deuxième mode de réalisation peut comporter, en plus de l'étape de recuit thermique qui vient d'être décrite, une étape d'irradiation UV. Cette première alternative a été précédemment décrite dans le cas du premier procédé 100 de fabrication de la cellule mémoire CBRAM 10 à base d'oxyde métallique selon le premier mode de réalisation de l'invention. L'étape d'irradiation UV permet avantageusement de casser des liaisons dans l'électrolyte solide en d'oxyde métallique, et donc de générer des défauts susceptibles de promouvoir des lacunes d'oxygène dans l'électrolyte solide en oxyde métallique.

Le premier procédé 300 de fabrication de la cellule mémoire CBRAM 20 à base d'oxyde métallique selon le deuxième mode de réalisation comporte finalement les étapes suivantes :
- dépôt, sur la couche d'interface du deuxième type INT2, de la couche de source d'ions ISL, la couche de source d'ions ISL comportant un élément conducteur soluble ;
- dépôt, sur la couche de source d'ions ISL, de la barrière de diffusion DB ;
- dépôt, sur la barrière de diffusion DB, de la couche de contact électrique CT.

La couche de source d'ions ISL, la barrière de diffusion DB et la couche de contact électrique CT forment la deuxième électrode E2.

Comme évoqué plus haut, la figure 5d illustre schématiquement la cellule mémoire CBRAM 20 à base d'oxyde métallique selon le deuxième mode de réalisation de l'invention, obtenue par le procédé 300 de fabrication.

Les figures 6a à 6d montrent schématiquement des étapes d'un deuxième procédé 400 de fabrication de la cellule mémoire CBRAM 20 à base d'oxyde métallique selon le deuxième mode de réalisation de l'invention (telle que représentée en figure 5d et 6d), dans lequel la cellule mémoire CBRAM 20 comporte la couche d'interface du deuxième type INT2.

Le deuxième procédé 400 de fabrication de la cellule mémoire CBRAM 20 à base d'oxyde métallique selon le deuxième mode de réalisation comporte tout d'abord les étapes suivantes :
- formation de la première électrode E1 ;
- formation, sur la première électrode E1, de l'électrolyte solide en oxyde métallique ML ;
- dépôt, sur l'électrolyte solide en oxyde métallique ML, de la couche d'interface du premier type INT1 comportant le métal de transition et l'élément chalcogène ;
- dépôt, sur la couche d'interface du premier type INT1, d'une couche C5 d'un élément conducteur soluble.

L'élément conducteur soluble de la couche C5 est typiquement déterminé par le type de matériau conducteur soluble que l'on souhaite utiliser par la suite pour réaliser la couche de source d'ions ISL. Dans le cas où l'on souhaite réaliser ultérieurement une couche de source d'ions ISL en cuivre Cu, l'élément conducteur soluble de la couche C3 est préférentiellement du cuivre Cu. La figure 6a montre schématiquement le résultat obtenu à l'issue des étapes qui viennent d'être citées.

Le deuxième procédé 400 de fabrication de la cellule mémoire CBRAM 20 à base d'oxyde métallique selon le deuxième mode de réalisation comporte ensuite une étape de recuit thermique, illustrée à la figure 6b. Cette étape de recuit thermique s'effectue typiquement à une température comprise entre 100°C et 450°C, et pendant une durée comprise entre 1 minute et 20 minutes.

Selon une première alternative, le deuxième procédé 400 de fabrication de la cellule mémoire CBRAM 20 à base d'oxyde métallique selon le deuxième mode de réalisation peut comporter, au lieu de l'étape de recuit thermique qui vient d'être décrite, une étape d'irradiation UV. Selon une deuxième alternative, le deuxième procédé 400 peut comporter l'étape de recuit thermique et l'étape d'irradiation UV. Ces première et deuxième alternatives ont été précédemment décrites dans le cas du premier procédé 100 de fabrication de la cellule mémoire CBRAM 10 à base d'oxyde métallique selon le premier mode de réalisation de l'invention.

L'étape de recuit thermique et/ou l'étape d'irradiation UV permettent la diffusion au moins partielle de l'élément conducteur soluble de la couche C5, précédemment déposée, dans la couche d'interface du premier type INT1. A l'issue de l'étape de recuit thermique et/ou de l'étape d'irradiation UV, la diffusion de l'élément conducteur soluble dans la couche d'interface du premier type INT1 permet l'obtention de la couche d'interface du deuxième type INT2, comportant le métal de transition, l'élément chalcogène et l'élément conducteur soluble. La figure 6c illustre schématiquement l'empilement ainsi obtenu à l'issue de l'étape de recuit thermique et/ou de l'étape d'irradiation UV.

Le deuxième procédé 400 de fabrication de la cellule mémoire CBRAM 20 selon le deuxième mode de réalisation comporte finalement les étapes suivantes :
- dépôt, sur la couche d'interface du deuxième type INT2, de la couche de source d'ions ISL, la couche de source d'ions ISL comportant l'élément conducteur soluble ;
- dépôt, sur la couche de source d'ions ISL, de la barrière de diffusion DB ;
- dépôt, sur la barrière de diffusion DB, de la couche de contact électrique CT.

La couche de source d'ions ISL, la barrière de diffusion DB et la couche de contact électrique CT forment la deuxième électrode E2.

La figure 6d illustre schématiquement la cellule mémoire CBRAM 20 (identique à la cellule 20 de la figure 5d) à base d'oxyde métallique selon le deuxième mode de réalisation de l'invention, obtenue par le procédé 400 de fabrication.

## Revendications

1. Dispositif de mémoire vive résistive (20) comportant :
- une première électrode (E1), dite « électrode inerte » ;
- un électrolyte solide en oxyde métallique (ML) s'étendant au moins partiellement sur la première électrode (E1) ;
- une deuxième électrode (E2), dite « électrode soluble », les première et deuxième électrodes étant respectivement agencées de part et d'autre dudit électrolyte solide en oxyde métallique (ML), la deuxième électrode (E2) étant apte à fournir des ions mobiles (5) circulant dans l'électrolyte solide en oxyde métallique (ML) vers la première électrode (E1) pour former un filament conducteur (6) entre les première et deuxième électrodes lorsqu'une tension est appliquée entre les première et deuxième électrodes ;
ledit dispositif (20) étant **caractérisé en ce qu'**il comporte une couche d'interface (INT2) comprenant :
∘ un métal de transition des groupes 3, 4, 5 ou 6 du tableau périodique des éléments ;
∘ un élément chalcogène ;
∘ un élément conducteur soluble ;
la couche d'interface (INT2) s'étendant au moins partiellement sur l'électrolyte solide en oxyde métallique (ML), la deuxième électrode (E2) s'étendant au moins partiellement sur la couche d'interface (INT2).

2. Dispositif (20) selon la revendication précédente **caractérisé en ce que** le métal de transition des groupes 3, 4, 5 ou 6 du tableau périodique des éléments est du titane Ti.

3. Dispositif (20) selon l'une quelconque des revendications précédentes **caractérisé en ce que** l'élément chalcogène est du tellure Te.

4. Dispositif (20) selon l'une quelconque des revendications précédentes **caractérisé en ce que** la deuxième électrode (E2) comporte :
- une première couche (ISL), dite « couche de source d'ions », réalisée à partir d'un élément conducteur soluble et s'étendant au moins partiellement sur la couche d'interface (INT2) ;
- une deuxième couche (DB), dite « barrière de diffusion », réalisée à partir d'un matériau conducteur et s'étendant au moins partiellement sur la couche de source d'ions (ISL) ;
- une troisième couche (CT), dite « couche de contact électrique », réalisée à partir d'un matériau conducteur et s'étendant au moins partiellement sur la barrière de diffusion (DB) ;
la barrière de diffusion (DB) étant apte à limiter au moins partiellement la diffusion du matériau conducteur de la couche de contact électrique (CT) vers la couche de sources d'ions (ISL) sur une gamme de température donnée.

5. Dispositif (20) selon la revendication précédente **caractérisé en ce que** la couche d'interface (INT2) et la couche de source d'ions (ISL) comportent le même élément conducteur soluble.

6. Procédé (300, 400) de fabrication d'un dispositif de mémoire vive résistive (20) selon l'une quelconque des revendications précédentes, comportant les étapes suivantes :
a) formation de la première électrode (E1) ;
b) formation, sur la première électrode (E1), de l'électrolyte solide en oxyde métallique (ML) ;
c) formation, sur l'électrolyte solide en oxyde métallique (ML), de la couche d'interface (INT2) ;
d) formation, sur la couche d'interface (INT2), de la deuxième électrode (E2).

7. Procédé (300) selon la revendication 6 pour la réalisation d'un dispositif de mémoire vive résistive (20) selon l'une quelconque des revendications 1 à 5, dont l'étape c) comporte les sous-étapes suivantes :
- dépôt, sur l'électrolyte solide en oxyde métallique (ML), d'une couche (C4) comportant l'élément chalcogène et l'élément conducteur soluble ;
- dépôt, sur la couche (C4) comportant ledit élément chalcogène et ledit élément conducteur soluble, d'une couche (C2) comportant le métal de transition des groupes 3, 4, 5 ou 6 du tableau périodique des éléments ;
- recuit thermique pour la diffusion au moins partielle dudit métal de transition dans la couche (C4) comportant ledit élément chalcogène et ledit élément conducteur soluble, et l'obtention de la couche d'interface (INT2) ; et dont l'étape d) comporte la sous-étape suivante :
- dépôt, sur la couche d'interface (INT2), d'une couche de source d'ions (ISL) comportant ledit élément conducteur soluble.

8. Procédé (400) selon la revendication 6 pour la réalisation d'un dispositif de mémoire vive résistive (20) selon l'une quelconque des revendications 1 à 5, dont l'étape c) comporte les sous-étapes suivantes :
- dépôt, sur l'électrolyte solide en oxyde métallique (ML), d'une couche (C5) comportant le métal de transition des groupes 3, 4, 5 ou 6 du tableau périodique des éléments et l'élément chalcogène ;
- dépôt, sur la couche (C5) comportant ledit métal de transition et ledit élément chalcogène, d'une couche (C6) comportant l'élément conducteur soluble ;
- recuit thermique pour la diffusion au moins partielle de l'élément conducteur soluble dans la couche (C5) comportant ledit métal de transition et ledit élément chalcogène, et l'obtention de la couche d'interface (INT2) ;
et dont l'étape d) comporte la sous-étape suivante :
- dépôt, sur la couche d'interface (INT2), d'une couche de source d'ions (ISL) comportant l'élément conducteur soluble.

9. Procédé (300, 400) selon l'une quelconque des revendications 7 ou 8 dont l'étape d) comporte les sous-étapes suivantes :
- dépôt, sur la couche de source d'ions (ISL) comportant l'élément conducteur soluble, d'une barrière de diffusion (DB) réalisée à partir d'un matériau conducteur ;
- dépôt, sur la barrière de diffusion (DB), d'une couche de contact électrique (CT) réalisée à partir d'un matériau conducteur ;
la couche de source d'ions (ISL), la barrière de diffusion (DB) et la couche de contact électrique (CT) formant la deuxième électrode (E2), la barrière de diffusion (DB) étant apte à limiter au moins partiellement la diffusion du matériau conducteur de la couche de contact électrique (CT) vers la couche de sources d'ions (ISL) sur une gamme de température donnée.
